# EUROPEAN PATENT APPLICATION

(11) **EP 1 808 962 A1**
(43) Date of publication of application: **18.07.2007**
(21) Application number: 05752550.3
(22) Date of filing: 17.06.2005
(51) Int. Cl.: H03H 17/06

(54) **DIGITAL FILTER AND ITS DESIGNING METHOD, DESIGING APPARATUS, AND PROGRAM FOR DESIGNING DIGITAL FILTER**

(30) Priority: 05.11.2004 JP 2004322454
(71) Applicant: Neuro Solution Corp., Tokyo 158-0091 (JP)
(72) Inventor: KOYANAGI, Yukio, 3360932 (JP)
(74) Representative: Vossius & Partner
(86) International application number: PCT/JP2005/011571
(87) International publication number: WO 2006/048958

(57) **Abstract**

An original filter is connected to an adjustment filter in the longitudinal way. The original filter has a first filter coefficient of a symmetric numeric string. The adjustment filter has a second filter coefficient which realizing an invert frequency amplitude characteristic B contacting with a frequency amplitude characteristic A of the original filter at the amplitude maximum value "1". By executing a product-sum calculation of the first filter coefficient and the second filter coefficient, it is possible to design a desired filter coefficient.

## Description

### [Background of the Invention]

### [Field of the Invention]

The present invention relates to a digital filter and its designing method, designing apparatus, and program for designing digital filter, and more particularly, to a designing method of FIR filter.

### [Description of the Related Art]

An FIR (Finite Impulse Response) filter is one type of digital filter. This FIR filter is a type of filter which is provided with tapped delay lines made up of a plurality of delayers, multiplies output signals of the respective taps several-fold, adds up the multiplication results and outputs the addition result, and has the following advantages. First, since the poles of a transfer function of the FIR filter exists only at the origin of the z-plane, the circuit is always stable. Second, if filter coefficients are symmetric, it is possible to realize a completely accurate rectilinear phase characteristic.

For this FIR filter, an impulse response expressed by a finite time length constitutes filter coefficients as are. Therefore, designing an FIR filter is equal to determining filter coefficients so that a desired frequency characteristic is obtained. Conventionally, an FIR filter is designed using the following method; filter coefficients are calculated based on a target frequency characteristic, the filter coefficients are subjected to windowing and a finite number of coefficient groups are obtained. Then, the coefficient groups obtained are subjected to an FFT (fast Fourier transform) to be transformed to a frequency characteristic and it is checked whether the frequency characteristic satisfies the target characteristic or not.

When filter coefficients are calculated from the target frequency characteristic, for example, a convolution, etc., using a Chebyshev approximation is performed based on a ratio between a sampling frequency and cutoff frequency. The number of coefficients obtained in this way becomes enormous and using all those coefficients will result in an extremely large number of taps and multipliers of the filter circuit, which is unrealistic. For this reason, the number of filter coefficients acquired through a convolution calculation is reduced to a degree that it falls within a range of practicality by means of windowing.

### [Summary of the Invention]

However, the frequency characteristic of the FIR filter obtained using the conventional design method depends on a window function and approximate expression, and therefore unless these are correctly set, it is not possible to obtain a preferable target frequency characteristic. However, it is generally difficult to set the window function or approximate expression appropriately. Furthermore, a truncation error occurs when windowing is performed, making it difficult to realize a desired frequency characteristic. Especially, there is a problem that it is extremely difficult to obtain an ideal frequency characteristic having an inhibition band (band between pass band and cutoff band) with a steep inclination.

A method of realizing a steep frequency characteristic by cascading a plurality of FIR filters produced using the above described conventional method is known (e.g., see Japanese Patent Laid-Open No. 5-243908). Furthermore, a method of adjusting a filter bank band by inserting a plurality of zero values between taps (between filter coefficients) of a tapped delay line is also known (e.g., see National Publication of International Patent Application No. 6-503450). However, according to these methods, the filter pass band becomes narrower than before adjustment and it is not possible to widen the bandwidth of the pass band to have a steep inclination.

The present invention has been implemented to solve the above described problems and it is an object of the present invention to provide a simple filter design method for widening a bandwidth of a frequency characteristic to have a steep inclination and a new FIR digital filter having an ideal frequency characteristic with a steep inclination.

In order to solve the above described problems, the digital filter design method according to the present invention includes a symmetric first step of generating a first filter coefficient of a numeric string, a second step of obtaining a second filter coefficient realizing an inverse frequency-amplitude characteristic contacting with a frequency-amplitude characteristic expressed by the first filter coefficient at the maximum amplitude value, and a third step of executing a calculation to obtain a third filter coefficient obtained when a first filter having the first filter coefficient and a second filter having the second filter coefficient are cascaded and determining the third filter coefficient generated through this calculation as the filter coefficient to be obtained.

Here, assuming that the numeric string constituting the first filter coefficient is {Hₘ, Hₘ₋₁, ... , H₁, H₀, H-₁, ... , H-₍ₘ₋₁₎, H-ₘ}, the second filter coefficient is obtained in the second step through a calculation {-kHₘ, -kHₘ₋₁, ... , -kH₁, -kH₀+(1+k), -kH-₁, ... , -kH-₍ₘ₋₁₎, -kH-ₘ} (k is an arbitrary positive number). Note that, in the first filter coefficient, its amplitude in a frequency-gain characteristic obtained by the result of a fast Fourier transform is normalized to become "1".

Besides, assuming that the numeric string constituting the first filter coefficient is {Hₘ, Hₘ₋₁, ..., H₁, H₀, H₀, H-₁, ..., H-₍ₘ₋₁₎, H₋ₘ}, the second filter coefficient is obtained in the second step by multiplying each numerical value of the numeric string (-k)-fold (k is an arbitrary positive number), applying a fast Fourier transform to the multiplied numeric string, adding k to each numerical value of the transformed numeric string, and applying an inverse fast Fourier transform to the resulting numeric string.

According to the present invention as described above, it is possible to simply design an FIR digital filter with a frequency characteristic having a relatively wide pass band and an inhibition band having a steep inclination without using any window function or approximate expression.

### [Brief Description of the Drawings]

FIG. 1 is a flow chart showing a procedure of an FIR digital filter design method according to an embodiment of the present invention;
FIG. 2 is a frequency characteristic diagram illustrating the concept of the FIR digital filter design method according to this embodiment;
FIG. 3 illustrates calculation contents when a second filter coefficient is calculated;
FIG. 4 illustrates a frequency-amplitude characteristic of an original band pass filter and a frequency-amplitude characteristic obtained when one to three adjustment filters are cascaded to this original band pass filter;
FIGS. 5A and 5B illustrate a principle of a variation in the frequency characteristic obtained when the adjustment filters of this embodiment are cascaded;
FIG. 6 illustrates a frequency characteristic obtained when three adjustment filters with k=1.5 are cascaded to the original band pass filter and an adjustment filter with k=1 is further cascaded in the final stage;
FIG. 7 illustrates a frequency-amplitude characteristic of the original low pass filter and a frequency-amplitude characteristic obtained when one to five adjustment filters are cascaded to this original low pass filter;
FIG. 8 illustrates an example of the structure of the digital filter according to this embodiment;
FIG. 9 illustrates filter coefficients of a basic low pass filter L4an;
FIG. 10 illustrates an example of the hardware structure of a basic low pass filter L4a4;
FIG. 11 illustrates a frequency characteristic of the basic low pass filter L4a4;
FIGS. 12A and 12B illustrate a frequency-gain characteristic of the basic low pass filter L4an;
FIG. 13 illustrates filter coefficients of a basic high pass filter H4sn; and
FIG. 14 illustrates filter coefficients of a basic band pass filter B4sn;
FIG. 15 is a block diagram illustrating another example of the structure of the digital filter according to this embodiment;
FIG. 16 is a block diagram illustrating another example of the structure of the digital filter according to this embodiment;
FIG. 17 is a block diagram illustrating still another example of the structure of the digital filter according to this embodiment.

### [Detailed Description of the Preferred Embodiments]

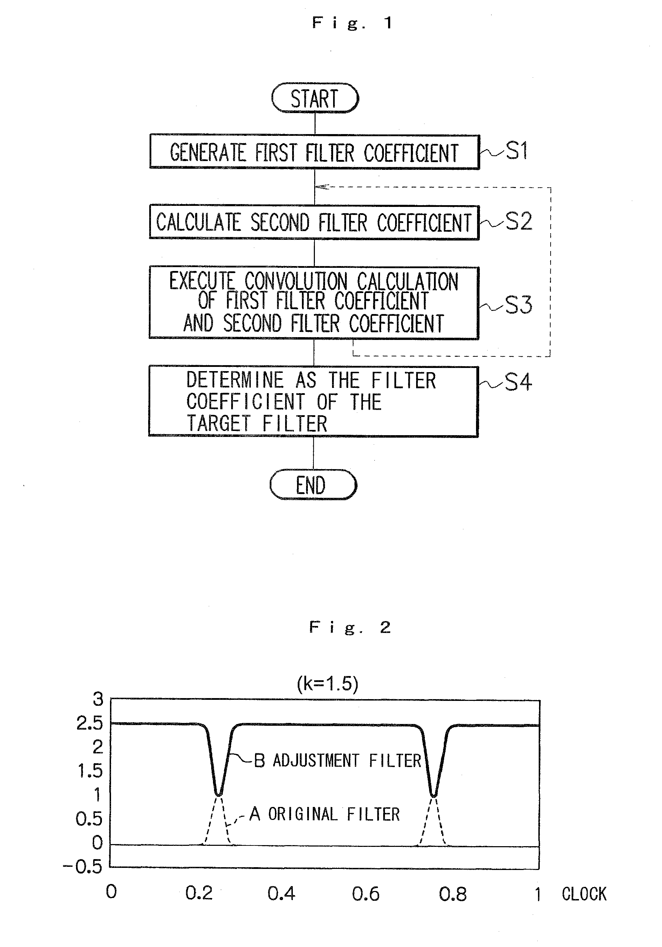

With reference now to the attached drawings, an embodiment of the present invention will be described below. FIG. 1 is a flow chart showing a procedure of an FIR digital filter design method according to an embodiment of the present invention. Furthermore, FIG. 2 is a frequency characteristic diagram illustrating the concept of the FIR digital filter design method according to this embodiment.

In FIG. 1, a first filter coefficient of a symmetric numeric string is generated first (step S1). The method of generating this first filter coefficient is not particularly limited in the present invention. If the numeric string of the filter coefficient is symmetric, a conventional design method using an approximate expression or window function may be used or the design method proposed by the present inventor in the past (e.g., Japanese Patent Application No. 2001-365146, Japanese Patent Application No. 2002-129168, Japanese Patent Application No. 2002-205014, Japanese Patent Application No. 2002-306315, Japanese Patent Application No. 2002-306316, Japanese Patent Application No. 2003-56265, etc.) may be used.

The filter design method proposed by the present inventor in the past can be summarized as follows. The first design method described in Japanese Patent Application No. 2001-365146 is a method whereby a plurality of amplitude values indicating a desired frequency characteristic are input, the input numeric string is subjected to an inverse Fourier transform, the numeric string obtained is subjected to windowing and thereby filter coefficients are obtained. Furthermore, the second design method described in Japanese Patent Application No. 2002-129168, Japanese Patent Application No. 2002-205014, Japanese Patent Application No. 2002-306315 and Japanese Patent Application No. 2002-306316 is a method whereby more than one basic unit filter made up of a predetermined basic numeric string is created and these basic unit filters are arbitrarily cascaded and thereby filter coefficients are obtained.

Furthermore, the third design method described in Japanese Patent Application No. 2003-56265 is a method whereby an FIR calculation is executed based on a filter coefficient made up of a predetermined basic numeric string, then moving average calculations are repeated n times on the calculation data by adding up original data before the calculation and previous data ahead of the original data by a predetermined amount of delay, adjusting the amplitude and outputting the data. Using the second design method or third design method is preferable from the standpoint that it is possible to obtain a frequency characteristic having a good attenuation characteristic with a small number of taps.

The frequency characteristic indicated by reference characteristic A in FIG. 2 is an example of a frequency-gain characteristic of an original filter realized by the first filter coefficient generated in step S1. Here, the gain and frequency of the frequency characteristic of the original filter are shown normalized with "1" (normalization).

Next, a second filter coefficient which attains an inverse frequency-amplitude characteristic (B in FIG. 2) contacting with a frequency-amplitude characteristic (A in FIG. 2) expressed by the first filter coefficient at the maximum amplitude value "1" thereof is obtained (step S2). That is, a symmetric second filter coefficient realizing a second frequency-amplitude characteristic having a contact point at a position where the maximum value is acquired in the first frequency-amplitude characteristic expressed by the first filter coefficient and having the minimum value at the contact point is obtained. When the frequency-amplitude characteristic has such features, any method can be used to generate the second filter coefficient, and, for example, the second filter coefficient can be obtained through the following calculation.

Specifically, assuming that the numeric string to be output when a single pulse is input to an original filter is {Hₘ, Hₘ₋₁, ..., H₁, H₀, H₋₁, ..., H₋₍ₘ₋₁₎ H₋ₘ} (being equal to the a numeric string of the first filter coefficient in this case), the second filter coefficient is obtained through a calculation {-kHₘ, -khₘ₋₁, ..., -kH₁, -kH₀+(1+k), -kH₋₁, ..., -kH₋₍ₘ₋₁₎, -kH₋ₘ} (k is an arbitrary positive number). That is, all coefficients other than the central value are multiplied (-k) -fold and only the central value is multiplied (-k)-fold and (1+k) is added thereto and the second filter coefficient is thereby obtained. Hereinafter, the filter having this second filter coefficient will be referred to as an "adjustment filter." Note that the first filter coefficient comprises an odd number of total coefficients including H₀ as a central value and is symmetric around the central value (Hₘ=H₋ₘ, Hₘ₋₁=H₋₍ₘ₋₁₎, ..., H₁=H₋₁). Also, in the first filter coefficient, its amplitude in a frequency-gain characteristic obtained from the result of a fast Furrier transform is normalized to "1".

On the other hand, in the case that a numeric string to be output when a single pulse is input to the original filter is expressed as {Hₘ, Hₘ₋₁, ..., H₁, H₀, H₀, H₋₁, ..., H₋₍ₘ₋₁₎, H₋ₘ} (which comprises an even number of total coefficients including two central values H₀ and is symmetric around the two central values. Hₘ=H₋ₘ, Hₘ₋₁=H₋₍ₘ₋₁₎, ..., H₁=H₋₁), it is difficult to obtain an adjustment filter through the above described coefficient calculation. Therefore, a second filter coefficient is obtained by multiplying numerical values of this numeric string (-k)-fold (k is an arbitrary positive number), executing an FFT processing to the multiplication result, adding k to numerical values of the transformed numeric string, and executing an inverse FFT processing to the addition result.

As is generally known, through an FFT processing to a numeric string, a frequency characteristic corresponding to the numeric string is obtained. Accordingly, through an FFT processing to the numeric string of a (-k)-fold first filter coefficient {-kHₘ, -kHₘ₋₁, ..., -kH₁, -kH₀, -kH₀, -kH-₁, ..., -kH-₍ₘ₋₁₎, -kH₋ₘ}, a frequency characteristic such as one produced by multiplying a frequency characteristic of the original filter by -k in the direction of gain can be obtained. Moreover, by adding k to the numeric string obtained from this FFT, the obtained frequency characteristic can be further shifted by k in the direction of gain. By executing an inverse FFT to a numeric string expressing the shifted frequency characteristic and then extracting its real numbers, a numeric string necessary to realize a frequency characteristic of an adjustment filter is obtained.

However, the numeric string obtained from the inverse FFT itself is not necessarily in the order to be used as it is as a filter coefficient of the adjustment filter. Specifically, in any type of digital filters, a numeric string of the filter coefficient is symmetric wherein a central value is the largest and other values become smaller as departing from the central value while changing in amplitude repeatedly. On the other hand, in a numeric string obtained through an inverse FFT to a frequency characteristic of an adjustment filter, a central value is the smallest and the values in both ends are the maximum.

Now, the numeric string obtained through the inverse FFT is spit into a first half section and a second half section and then the order is exchanged so as that the central value comes into both sides. For example, providing a numeric string is comprised of 512 coefficients, by exchanging the coefficient order such as a first coefficient to a 257th coefficient (hereinafter expressed as "1->257"), 2->258, 3->259, ..., 256->512, 257->1, 258->2, ..., 512->256, a central value becomes the maximum value around which the numeric string is symmetric.

Although the numeric string obtained in this way can be determined as a filter coefficient as it is of an adjustment filter, it is preferable to reduce the number of coefficients to the necessary number by executing a rounding calculation. The rounding calculation executed here may be simply rounding a certain digit and lower of the numerical value (cut off, round up, round off, and the like), and, for example, the following rounding calculation may be executed to simplify the values of the filter coefficient to be obtained.

For example, assuming that a numeric string after exchanging the order is y bit data (data with an absolute value of zero or more but one or less), the x bit (x<y) data which is converted to an integer by multiplying the y bit data 2^{x}-fold and by rounding the decimal fractions (cut off, round up, round off, and the like) is used as a filter coefficient. Also, y bit data may be subjected to a rounding processing to obtain x bit (x<y) data and then the obtained data may be multiplied 2^{x}-fold so as to be converted to an integer.

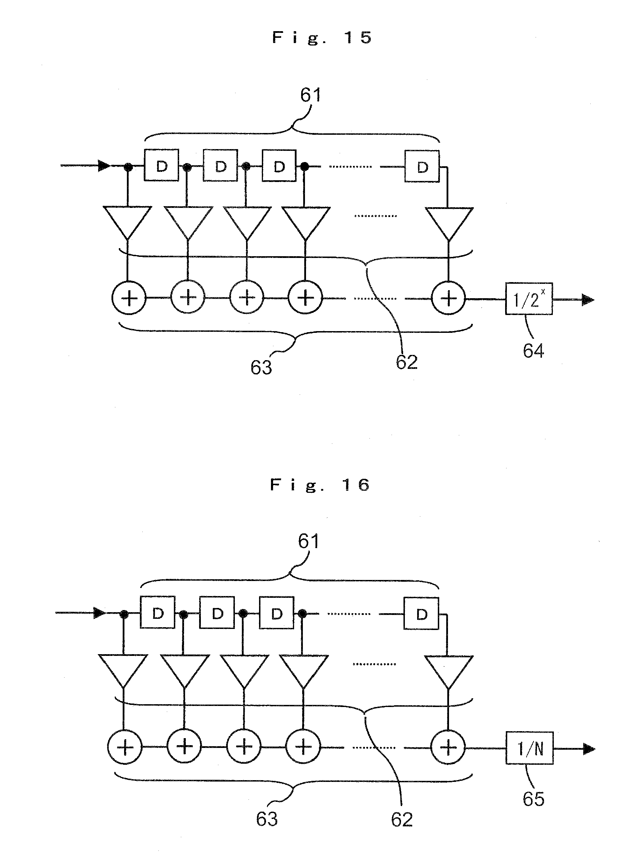

Performing such conversion-to-integer rounding operation, it will become possible to configure a digital filter, as shown in FIG. 15,tomultiplyfilter coefficients in integer for output signals from respective taps of tapped delay line consisting of a plurality of delay devices (D-type flip-flop) 61 with a plurality of coefficient multipliers 62 individually, add the respective multiplied output all together with a plurality of adders 63 and thereafter multiply them by 1/2 collectively with one shift computing unit 64. Moreover, integer filter coefficients can be expressed with addition in a binary system as in 2ⁱ+2^{j}+... (i and j are any integers). Thereby, instead of a multiplier, a bit shift circuit can be adopted to configure a coefficient multiplier 62, which reduces a large number of multipliers, adders, etc., to be used in the FIR filter as a whole and slims down the circuit dimensions of the digital filter dramatically.

As another example of conversion-to-integer rounding operation, the numeric string of filter coefficients may be subjected to rounding of multiplying by N (N is a value beside power-of-two) on the fractional part (cut off, round up, round off, and the like). In case of performing such conversion-to-integer N-fold rounding operation, it will become possible to configure a digital filter to multiply, as shown in FIG. 16, filter coefficients in integer for output signals from respective taps of tapped delay line consisting of a plurality of delay devices (D-type flip-flop) 61 with a plurality of coefficient multipliers 62 individually, add the respective multiplied output all together with a plurality of adders 63 and thereafter multiply them by 1/N collectively with one multiplier 65. Moreover, integer filter coefficients can be expressed with addition in a binary system as in 2ⁱ+2^{j}+... (i and j are any integers). Thereby, instead of a multiplier, a bit shift circuit can be adopted to configure a coefficient multiplier so as to simplify configuration of the digital filter to be implemented.

In addition, in case of multiplying the numeric string by 2^{x} (x is an integer), it is possible to execute bits-unit rounding on filter coefficients while it is possible to execute inter-bits rounding on filter coefficients in case of multiplying a numeric string by N. Bits-unit rounding refers to processing to multiply filter coefficients by an integer multiple of 1/2^{x} such as rounding all numerical values falling within the range of 2^{x} to 2^{x+1} to 2^{x} in case of multiplying a coefficient value by 2^{x} to cut off the fractional part for example. In addition, inter-bits rounding refers to processing to multiply filter coefficients by an integer multiple of 1/N such as rounding all numerical values falling within the range of N to N+1 to N in case of multiplying a coefficient value derived by N (for example, 2^{x-1}<N<2^{x}) to cut off the fractional part for example. By performing rounding multiplied by N, it is possible to adjust a value of filter coefficients to undergo conversion-to-integer into any value beside power-of-two. This will make it possible to delicately adjust the filter coefficient count (tap count) for use in an adjustment filter.

Otherwise, as an example of an rounding operation accompanying conversion-to-integer processing, all data values of y-bits filter coefficients smaller than 1/2^{x} may be regarded as zero while, as for the data values equal to or larger than 1/2^{x}, the data values are subjected to multiplying 2^{x+x}-fold (x+X < y) and rounding the decimal fractions (cut off, round up, round off, and the like).

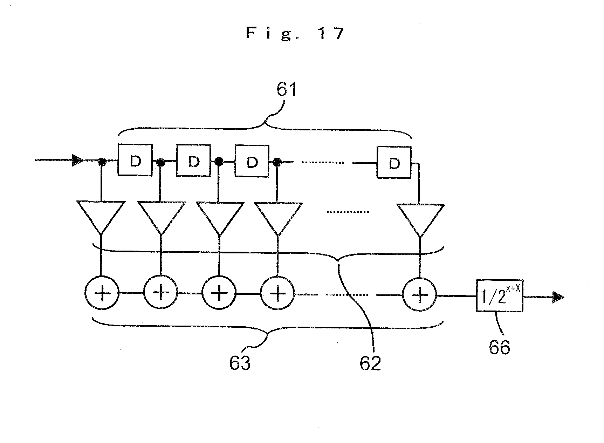

In case of performing such a rounding operation, it will become possible to configure a digital filter to multiply, as shown in FIG. 17, filter coefficients in integer for output signals from respective taps of tapped delay line consisting of a plurality of delay devices (D-type flip-flop) 61 with a plurality of coefficient multipliers 62 individually, add the respective multiplied output all together with a plurality of adders 63 and thereafter multiply them by 1/2^{x+X} collectively with one shift operation device 66. Moreover, integer filter coefficients can be expressed with addition in a binary system as in 2ⁱ+2^{j}+... (i and j are any integers). Thereby, instead of a multiplier, a bit shift circuit can be adopted to configure a coefficient multiplier so as to simplify configuration of the digital filter to be implemented.

In addition, it is possible to significantly reduce the filter coefficient count (tap count) by regarding all data values smaller than 1/2^{x} as zero for cut-off and, at the same time, it is possible to derive filter coefficients having a good accuracy of (x+X) bits being abundant in bits count compared with x bits . Therefore a good frequency characteristic can be derived as well.

In the present embodiment, the numeric string obtained through such rounding operation is determined as the second filter coefficient which indicates a frequency characteristic of the target adjustment filter. Once the second filter coefficient is obtained in this way, a calculation is executed to obtain a third filter coefficient which is obtained when the original filter having a first filter coefficient and the adjustment filter having a second filter coefficient are cascaded (step S3). By cascading the original filter and adjustment filter, the first filter coefficient and second filter coefficient are multiplied and added up and a new filter coefficient is thereby created. Then, the third filter coefficient generated in such manner is determined as the filter coefficient of the target filter (step S4).

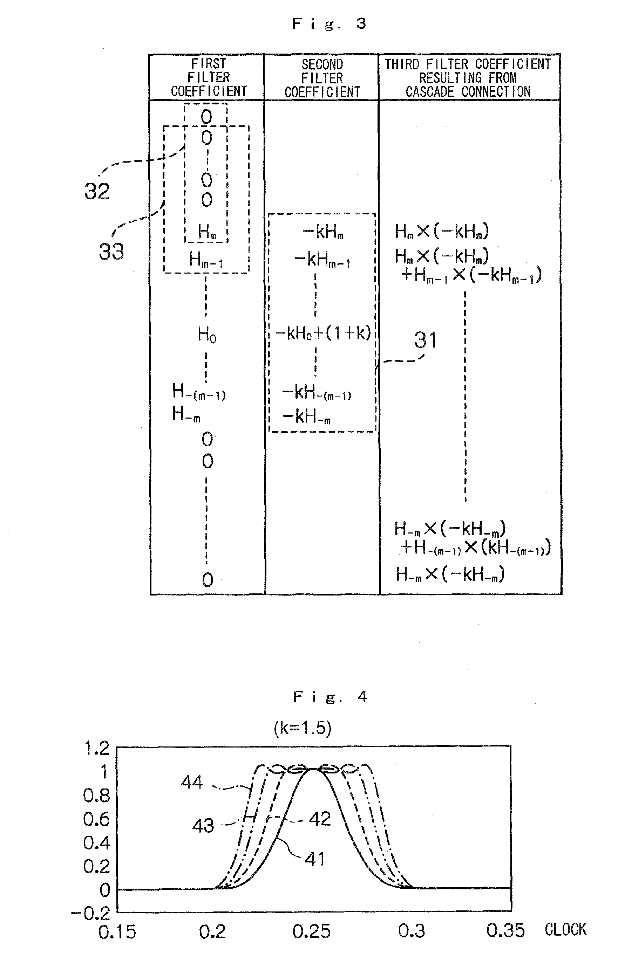

FIG. 3 illustrates calculation contents in step S3. As shown in this FIG. 3, in step S3, a product-sum calculation between (2m+1) (2m+1 represents the total number of elements of the numeric string making up the first filter coefficient) elements of the numeric string making up the first filter coefficient and (2m+1) elements of the numeric string of making up the second filter coefficient is executed to obtain the numeric string of the third filter coefficient.

In this product-sum calculation, for the second filter coefficient, the entire numeric string of {-kHₘ, -kHₘ₋₁, ... , -kH₁, -kH₀+(1+k), -kH₋₁, ..., -kH-₍ₘ₋₁₎, -kH₋ₘ} is always subj ected to a multiplication and addition in a fixed manner. On the other hand, for the first filter coefficient, assuming that there are "0" strings before and after the numeric string {Hₘ, Hₘ₋₁, ... , H₁, H₀, H₋₁, ... , H₋₍ₘ₋₁₎, H₋ₘ}, the numeric string of (2m+1) elements including these "0" values are subjected to a product-sum calculation. At this time, when the nth numerical value in the third filter coefficient is calculated, the nth numerical value of the first filter coefficient and the numeric string of (2m+1) elements ahead thereof are subjected to a multiplication and addition.

For example, when the first numerical value of the third filter coefficient is calculated, the entire numeric string {-kHₘ, -kHₘ₋₁, ..., -kH₁, -kH₀+(1+k), -kH₋₁, ..., -kH₋₍ₘ₋₁₎, -kH₋ₘ} (array enclosed by a dotted line indicated by reference numeral 31) of the second filter coefficient and the first numerical value of the first filter coefficient and a numeric string of (2m+1) elements {0, 0, ..., 0, Hₘ} (array enclosed by a dotted line indicated by reference numeral 32) ahead thereof are subjected to a calculation of summing the products of corresponding elements of the array. That is, the calculation result in this case is (Hₘ×(-kH₋ₘ)).

Furthermore, when the second numerical value of the third filter coefficient is calculated, the entire numeric string of the second filter coefficient {-kHₘ, -kHₘ₋₁, ..., -kH₁, -kH₀+(1+k), -kH₋₁, ... , -kH-₍ₘ₋₁₎, -kH₋ₘ} (array enclosed by a dotted line indicated by reference numeral 31) and the second numerical value of the first filter coefficient and a numeric string of (2m+1) elements {0, 0, ..., 0, Hₘ, Hₘ₋₁} (array enclosed by a dotted line indicated by reference numeral 33) ahead thereof are subjected to a calculation for summing the products of the corresponding elements of the array. That is, the calculation result in this time is (Hₘ×(-kH₋ₘ)+Hₘ₋₁×(-kH-₍ₘ₋₁₎)). In the same way, a numeric string of (2x (2m+1) -1) elements making up the third filter coefficient will be calculated.

Here, the case where one adjustment filter is cascaded to the original filter has been described as an example, but a plurality of adjustment filters may also be cascaded. In this case, as shown with the dotted line arrow in FIG. 1, the third filter coefficient generated in step S3 is newly regarded as the first filter coefficient and the process is returned to step S2. A second filter coefficient is obtained again (a new adjustment filter is generated) based on the new first filter coefficient (corresponds to a numeric string output from the first adjustment filter when a single pulse is input to the original filter).

Furthermore, the new first filter coefficient and new second filter coefficient generated in this way are subjected to a product-sum calculation and a new third filter coefficient is thereby calculated which is obtained when a new adjustment filter is further cascaded. Such a calculation is repeated the number of times corresponding to the number of adjustment filters to be cascaded. Then, the third filter coefficient generated through the final stage of the step S3 is determined as the filter coefficient of the target filter.

FIG. 4 illustrates a frequency-amplitude characteristic of an original filter (band pass filter) and a frequency-amplitude characteristic obtained when one to three adjustment filters are cascaded to this original filter. In FIG. 4, reference numeral 41 denotes a frequency-amplitude characteristic of the original filter, 42 denotes a frequency-amplitude characteristic obtained when one adjustment filter is cascaded, 43 denotes a frequency-amplitude characteristic obtained when two adjustment filters are cascaded and 44 denotes a frequency-amplitude characteristic obtained when three adjustment filters are cascaded.

As shown in this FIG. 4, by cascading the adjustment filters of this embodiment to the original filter, it is possible to widen the pass band of the filter and make the inclination of the inhibition band steeper. Increasing the number of the cascaded adjustment filters allows a filter characteristic with a wider pass band and with steeper inclination to be obtained.

This FIG. 4 shows a frequency characteristic when the value of parameter k in calculating the second filter coefficient from the first filter coefficient is assumed to be 1.5. As shown in FIG. 4, when k≠1, a certain degree of overshoot and ringing appear at the vertex of the frequency characteristic. However, when k=1, no overshoot or ringing appears at the vertex of the frequency characteristic and the characteristic becomes flat.

In case of that the filter coefficient obtained in the step S3 is newly regarded as the first filter coefficient, a plurality of maximum amplitude values (local maximum values) exist in a frequency-amplitude characteristic expressed with the new first filter coefficient due to effects of overshoot and the like (see a characteristic indicated with the reference number 42 in FIG. 4) when k≠1. The second filter coefficient which realizes an inverse frequency-amplitude characteristic contacting at the maximum amplitude value (a central amplitude value in the direction of frequency axis) existing only in the case of the primal original filter instead of the maximum amplitude values occurred due to overshoot and the like will be obtained. That is, the maximum amplitude value in the present embodiment indicates the maximum value "1" in amplitude which is normalized with "1" in the frequency-amplitude characteristic.

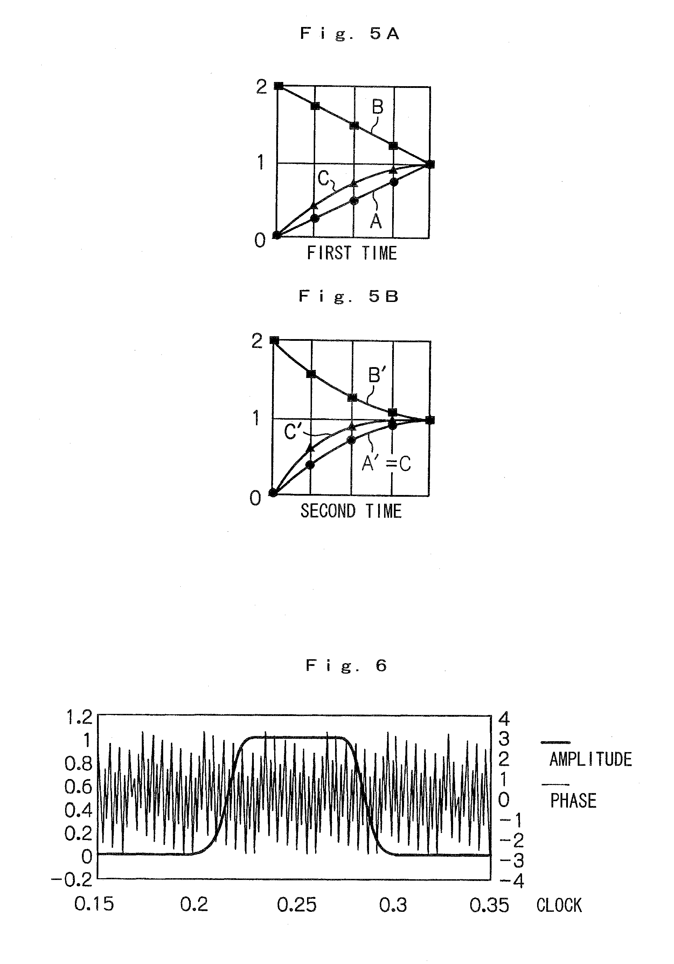

FIGS. 5A and 5B illustrate a principle of a variation in the frequency characteristic obtained when the adjustment filters of this embodiment are cascaded. Note that this FIGS. 5A and 5B are intended to explain the basic principle and it does not match the waveform of the frequency characteristic shown in FIG. 4. This FIGS. 5A and 5B show a principle when k=1 is set.

FIG. 5A shows a variation in the frequency-amplitude characteristic when the first adjustment filter is cascaded to the original filter. In FIG. 5A, reference characteristic A shows the frequency-amplitude characteristic of the original filter, B shows the frequency-amplitude characteristic of the first adjustment filter having a second filter coefficient generated from the first filter coefficient of the original filter and C shows the frequency-amplitude characteristic obtained when the original filter and the first adjustment filter are cascaded.

That is, the new frequency-amplitude characteristic C when one adjustment filter is cascaded to the original filter takes the form of the frequency-amplitude characteristic A of the original filter multiplied by the frequency-amplitude characteristic B of the adjustment filter. When the second adjustment filter is further cascaded, the third filter coefficient corresponding to the frequency-amplitude characteristic C generated in this way is newly used as the first filter coefficient and a new second filter coefficient for the second adjustment filter is obtained.

FIG. 5B shows a variation in the frequency-amplitude characteristic when a second adjustment filter is further cascaded. In FIG. 5B, reference characteristic A' shows the frequency-amplitude characteristic when the first adjustment filter is cascaded and is identical to the frequency-amplitude characteristic C obtained using the procedure in FIG. 5A. Reference characteristic B' shows the frequency-amplitude characteristic of the second adjustment filter having a new second filter coefficient generated from the new first filter coefficient corresponding to the frequency-amplitude characteristic A'. Reference characteristic C' shows a new frequency-amplitude characteristic obtained when a second adjustment filter is further cascaded and it takes the form of a multiplication between the two frequency-amplitude characteristics A', B'.

Though not shown here, when a third adjustment filter is further cascaded, a filter coefficient corresponding to the new frequency-amplitude characteristic C' generated using the procedure in FIG. 5B is used again as the first filter coefficient and a new second filter coefficient for the third adjustment filter is calculated. Then, a new frequency-amplitude characteristic is obtained according to a procedure similar to the above described procedure.

Thus, by cascading a plurality of adjustment filters to the original filter, it is possible to widen the pass band of the filter and make the inclination of the inhibition band steeper. When k=1, the frequency-amplitude characteristic of the original filter and the frequency-amplitude characteristic of the adjustment filter are axisymmetric with respect to the line whose amplitude is "1". Therefore, nomatter howmany adjustment filters are connected, the frequency-amplitude characteristic of the new filter obtained through the multiplication never exceeds the line whose amplitude is "1" and no overshoot or ringing occurs. From this, the value of k is preferably set to "1".

On the other hand, when the value of k is set to a value greater than 1, overshoot or ringing of a certain degree occurs, but it is possible to increase the rate of the pass band that can be widened through the connection of one adjustment filter. Therefore, when the pass band is preferably widened efficiently using a small number of adjustment filters, the value of k is preferably increased. In this case, by connecting an adjustment filter with k=1 in the final stage after cascading a plurality of adjustment filters for which the second filter coefficient is obtained assuming k≠1, it is possible to efficiently widen the pass band and obtain a good frequency characteristic with no overshoot or ringing.

FIG. 6 illustrates a frequency characteristic obtained when three adjustment filters with k=1.5 are cascaded to the original filter and an adjustment filter with k=1 is further cascaded in the final stage. As is appreciated from this FIG. 6, when the adjustment filter with k=1 is connected in the final stage, it is possible to obtain a good frequency characteristic having a wide pass band, inhibition band with a steep inclination and flat vertex. Furthermore, since the filter coefficient is of a symmetric type, the linearity of the phase can also be secured. Furthermore, by adjusting the value of k to k<1, the bandwidth of the pass frequency band can also be finely adjusted.

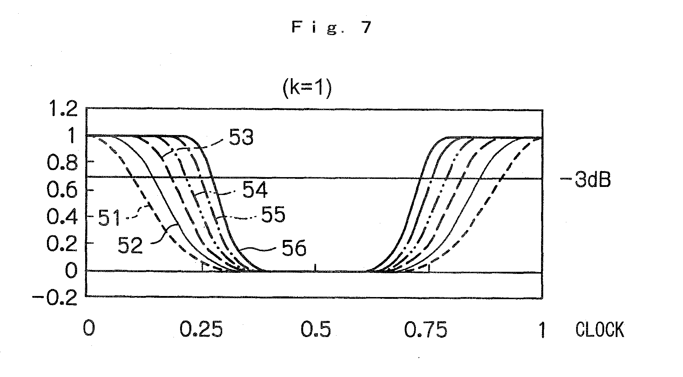

A design example of a band pass filter has been described so far, but a low pass filter or high pass filter can also be designed using a similar procedure. FIG. 7 illustrates a frequency-amplitude characteristic of the original low pass filter and a frequency-amplitude characteristic obtained when 1 to 5 adjustment filters are cascaded to this original low pass filter. This FIG. 7 shows the frequency characteristic assuming k=1.

In FIG. 7, reference numeral 51 denotes a frequency-amplitude characteristic of the original low pass filter and 52 to 56 denote frequency-amplitude characteristics obtained when 1 to 5 adjustment filters are cascaded respectively. As shown in this FIG. 7, in the case of the low pass filter as well as the band pass filter in FIG. 4, it is possible to widen the bandwidth of the pass band of the filter and make the inclination of the inhibition band steeper by cascading the adjustment filter. Furthermore, it is also possible to obtain a filter characteristic with a wider pass band and steeper inclination by increasing the number of adjustment filters cascaded.

The device for implementing the filter design method according to this embodiment described above can be realized any one of a hardware structure, DSP or software. For example, when the device is realized by software, the filter design device according to this embodiment is actually constructed of a CPU, MPU, RAM or ROM of a computer and the device can be realized by operating a program stored in a RAM, ROM or hard disk, etc.

For example, filter coefficients of various basic filters about the second or third design method are stored as data in a storage device such as a RAM, ROM or hard disk. When the user instructs an arbitrary combination or connection order concerning the basic filters, the CPU calculates a first filter coefficient of the original filter corresponding to the instructed contents using the data of the filter coefficients stored in the storage device.

Furthermore, when the user instructs and inputs parameter k on the adjustment filter and the number of cascade connections of the adjustment filter, the CPU can calculate a second filter coefficient from the first filter coefficient and further calculate a third filter coefficient from the second filter coefficient. In this case, the storage device corresponds to the filter coefficient storage means and the CPU corresponds to the calculation means of the present invention.

When the user instructs the combination and connection order of the respective basic filters, parameter k on the adjustment filter and the number of cascade connections of the adjustment filter, etc., the user interface can be constructed arbitrarily. For example, the user interface may be adapted so as to be able to select the type of a basic filter from a list shown on a screen by operating a keyboard or mouse and input values of various parameters by operating the keyboard or mouse. The CPU acquires information input in this way and obtains the filter coefficient corresponding to the contents instructed by the input information through the above described calculation.

Furthermore, various basic filters are iconized and shown on the display screen (filter coefficients corresponding to the respective icons are stored as data in the storage device) and the user combines and arranges these icons in an arbitrary combination on the display screen by operating the keyboard and mouse. Furthermore, the user inputs other necessary parameters by operating the keyboard and mouse. The embodiment may also be adapted so that the CPU automatically calculates and determines the array of icons and filter coefficients corresponding to the input parameters.

Furthermore, it is also possible to execute calculations to sequentially obtain a first filter coefficient, second filter coefficient and third filter coefficient using the function features of a spreadsheet installed in a personal computer, etc. Calculations in this case are executed through the CPU, ROM, RAM, etc., of the personal computer in which the spreadsheet is installed.

Furthermore, the calculated filter coefficients may be automatically FFT-transformed and the result may be displayed on the display screen as a frequency-gain characteristic diagram. By doing so, it is possible to visually check the frequency characteristic of the designed filter and carry out the filter design more easily.

Such a f i lter design device can be realized by recording a program which causes a computer to operate so as to realize the function of this embodiment in a storage medium such as a CD-ROM and by causing the computer to read this program. As the storage medium for recording the program, it is possible to use a flexible disk, hard disk, magnetic tape, optical disk, magneto-optical disk, DVD or non-volatile memory card, etc., in addition to CD-ROM. Furthermore, the above described program may also be downloaded to the computer through a network such as the Internet.

Note that not only in the case where the above described functions of the embodiment are realized by the computer executing the supplied program but also in the case where the program is cooperating with an OS (operating system) or other application software operating on the computer to execute the functions of the above described embodiment or in the case where a function enhancement board or function enhancement unit of the computer is executing the whole or part of the processing of a supplied program to execute the functions of the above described embodiment, such a program is also included in the embodiment of the present invention.

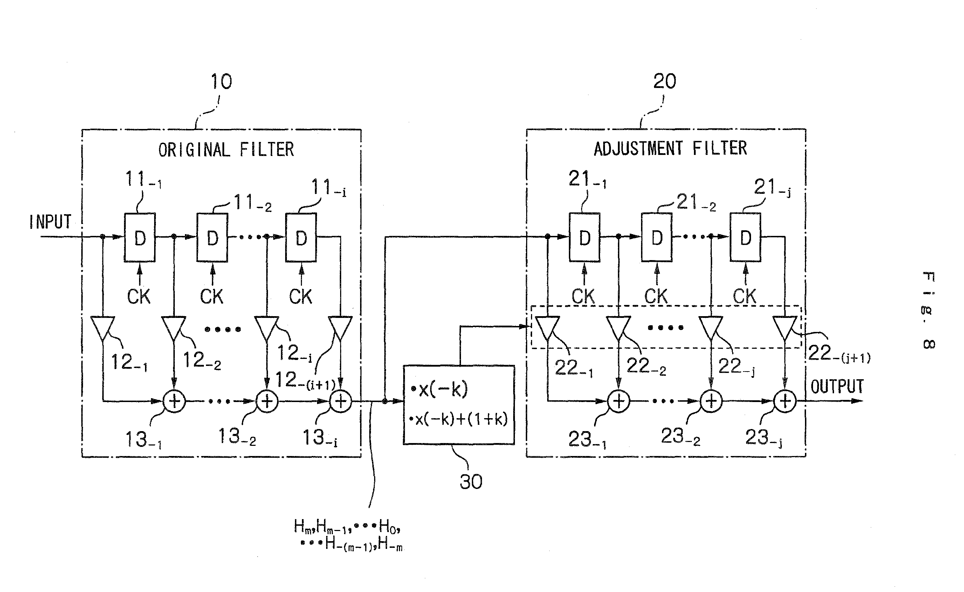

Next, the structure of the digital filter according to this embodiment will be described. FIG. 8 illustrates one example of the structure of the digital filter according to this embodiment.

The digital filter shown in FIG. 8 is constructed of one original filter 10 and one adjustment filter 20 cascaded together. The original filter 10 is constructed of i D-type flip flops 11₋₁ to 11₋ᵢ, (i+1) coefficient units 12₋₁ to 12₋₍ᵢ₊₁₎ and i adders 13₋₁ to 13₋ᵢ cascaded together.

The i D-type flip flops 11₋₁ to 11₋ᵢ sequentially delay input data by 1 clock CK at a time. The (i+1) coefficient units 12₋₁ to 12-₍ᵢ₊₁₎ multiply signals extracted from the input/output taps of the respective D-type flip flops 11₋₁ to 11₋ᵢ by symmetric first filter coefficients. The i adders 13₋₁ to 13₋ᵢ add up all the multiplication results from the coefficient units 12₋₁ to 12₋₍ᵢ₊₁₎ and outputs the addition result.

The data output from the original filter 10 is input to the adjustment filter 20 and at the same time input to the filter coefficient calculation section 30. The filter coefficient calculation section 30 calculates second filter coefficients to be set in the adjustment filter 20 based on the output data from the original filter 10.

That is, assuming that the data string output from the original filter 10 when a single pulse is input to the original filter 10 is {Hₘ, Hₘ₋₁, ..., H₁, H₀, H₋₁, ..., H₋₍ₘ₋₁₎, H₋ₘ}, the filter coefficient calculation section 30 calculates second filter coefficients through a calculation {-kHₘ, -kHₘ₋₁..., -kH₁, -kH₀+(1+k), -kH₋₁, ..., -kH₋₍ₘ₋₁₎, -kH₋ₘ} (k is an arbitrarily set positive number). The second filter coefficients obtained are set in the (j+1) coefficient units 22₋₁ to 22-₍ⱼ₊₁₎ in the adjustment filter 20 respectively.

The adjustment filter 20 is constructed of j (j>i) D-type flip flops 21-₁ to 22-ⱼ, (j+1) coefficient units 22₋₁ to 22-₍ⱼ₊₁₎ and j adders 23-₁ to 23-ⱼ cascaded together. The j D-type flip flops 21-₁ to 21₋ⱼ sequentially delay the input data from the original filter 10 by 1 clock CK at a time. (j+1) coefficient units 22₋₁ to 22-₍ⱼ₊₁₎ multiply the signals extracted from the input/output taps of the respective D-type flip flops 21-₁ to 21-ⱼ by the symmetric second filter coefficients respectively. j adders 23-₁ to 23-ⱼ add up the multiplication results from the respective coefficient units 22-₁ to 22-₍ⱼ₊₁₎ and output the addition result.

When the above-mentioned conversion-to-integer rounding operation is performed in obtaining the filter coefficients for the adjustment filter 20, the adjustment filter 20 may be configured as any one of FIGS. 15 to 17. Also, the original filter 10 may be configured as any one of FIGS. 15 to 17 by performing the conversion-to-integer rounding operation likewise.

Here, an example of the structure with only one adjustment filter 20 cascaded to the original filter 10 is shown, but when two or more adjustment filters 20 are cascaded, the structure shown in FIG. 8 may be followed by a plurality of structures similar to those of the filter coefficient calculation section 30 and adjustment filter 20 (however, the number of coefficients necessary for the adjustment filters increases as the stage number increases).

Furthermore, instead of the cascade connection of the original filter 10 and adjustment filter 20 as shown in FIG. 8, it is possible to make up one digital filter with a plurality of D-type flip flops, apluralityof coefficient units and a plurality of adders and set the final filter coefficients obtained using the procedure shown in FIG. 1 in the plurality of coefficient units in the digital filter.

Here, as described above, according to the filter design method of this embodiment, when the number of cascaded adjustment filters is increased, the number of filter coefficients necessary for the adjustment filters in the posterior stages increases. Therefore, in order to reduce the number of taps in the entire digital filter, it is preferable to reduce the number of filter coefficients used in the original filter which constitutes the original source. In this respect, according to the third design method described in Japanese Patent Application No. 2003-56265 already applied by the present inventor, it is possible to construct an original filter having a good frequency characteristic with quite a small number of taps. The contents of Japanese Patent Application No. 2003-56265 related to this third design method will be extracted and described below. Note that parameters such as m, i, j, and x will be used in the following explanations, but they are completely different in meaning from those described above.

The third design method which has already been applied for a patent defines several types of basic filter groups having specific impulse responses and realizes an FIR filter having a desired frequency characteristic in the form of a hardware wherein those basic filter groups are arbitrarily cascaded. The basic filters are roughly divided into three types of a basic low pass filter, basic high pass filter and basic band pass filter. These basic filters will be described below.

### <Basic low pass filter Lman (m and n are variables, m is an arbitrary number, n is a natural number)>

A basic low pass filter Lman is configured with an FIR calculation section that uses a numeric string "-1, m, -1" as filter coefficients and a moving average calculation section that sequentially performs a moving average calculation to a numeric string output from the FIR calculation section. The moving average calculation section sequentially applies a moving average calculation to the original numeric string "-1, m, -1" such as by performing a moving average calculation wherein a present numeric string and a numeric string shifted by one sample (one clock) from the present numeric string are added together with weighting (the total weighting value is "1") and by performing the same moving average calculation again to the obtained numeric string.

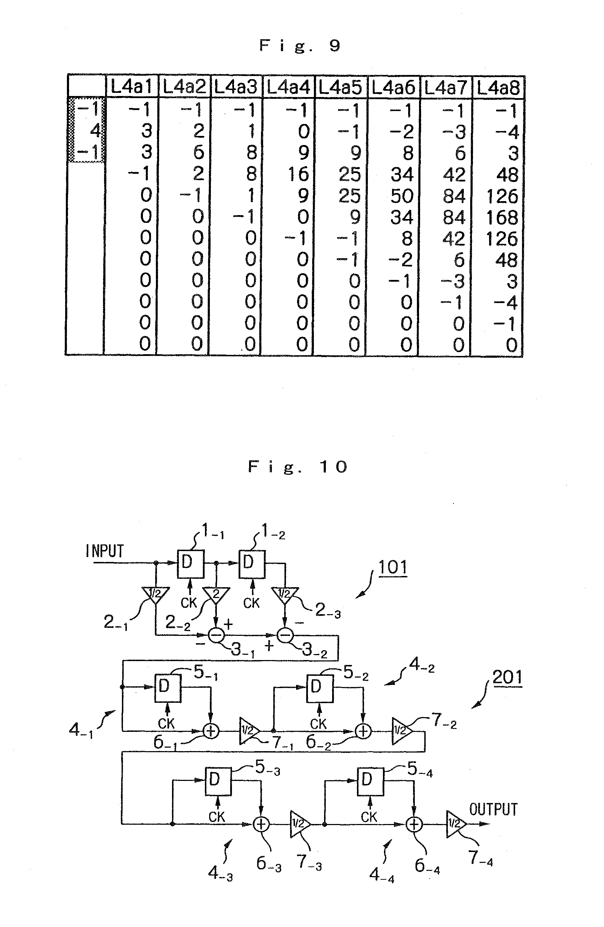

FIG. 9 illustrates filter coefficients of a basic low pass filter L4an (when m=4) (a numeric string obtained when a numeric string of filter coefficients possessed by an FIR calculation section is subjected to a moving average calculation in a moving average calculation section). The numeric strings of filter coefficients shown in FIG. 9 are not normalized with "1" but the numerical values are converted into integers to be explained easily.

In FIG. 9, in obtaining the jth filter coefficient from top of the nth column by a moving average calculation, the jth data from top of the (n-1)th data column and the jth data from top of the data column shifted by one sample (one clock) from the (n-1) th data column are added together with weighting.

For example, the first numerical value "-1" from top of the basic low pass filter L4a1 (first column) is obtained by adding the original data "-1" in first of the 0th column and the data "0" preceding thereof by one sample. The second numerical value "3" is obtained by adding the original data "4" in second of the 0th column and the data "-1" preceding thereof by one sample. The third numerical value "3" is obtained by adding the original data "-1" in third of the 0th column and the data "4" preceding thereof by one sample. The fourth numerical value "-1" is obtained by adding the original data "0" in forth of the 0th column and the data "-1" preceding thereof by one sample. The weighting calculation is omitted in FIG. 9 in order to easily express numerical values in integers.

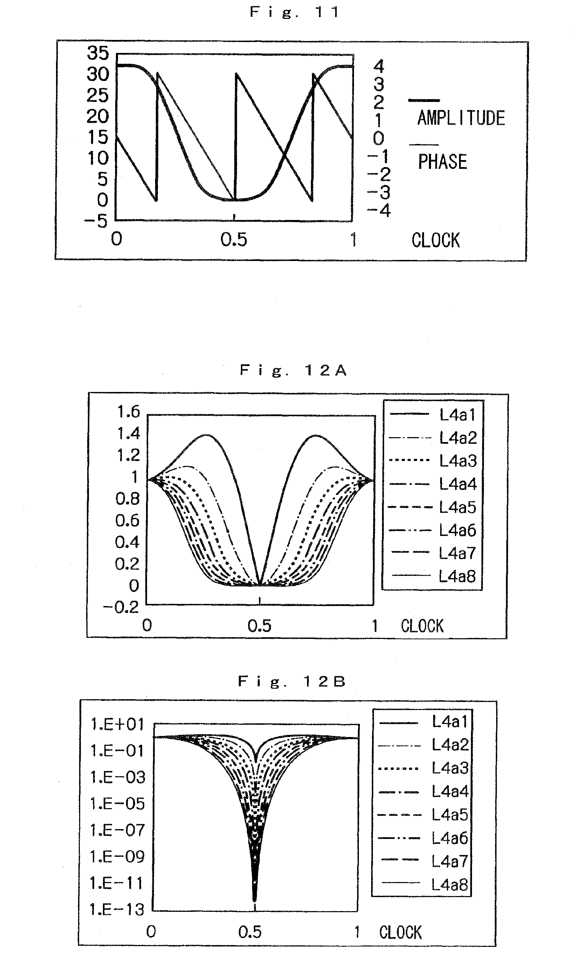

Filter coefficients of any basic low pass filter L4an shown in FIG. 11 consist of a symmetric numerical string characterized in that the sums of every other value have the same sign and the same value (e.g., in the case of thebasiclowpassfilterL4a4, -1+9+9+(-1)=16, 0+16+0=16).

When these numeric strings are actually used as filter coefficients, the amplitude when a numeric string of filter coefficients was subjected to an FFT transforming is adjusted to "1", whereby a gain is normalized to "1". For example, a numeric string of filter coefficients actually used in the FIR calculation section is not "-1, 4, -1", but "-1/2, 2, -1/2". Additionally, a numeric string actually used as filter coefficients (first filter coefficients) of an original filter after a moving average calculation is not {-1, 0, 9, 16, 9, 0, -1}, but "{-1, 0, 9, 16, 9, 0, -1}/32, for example.

When the numerical string normalized as shown above is used as filter coefficients, the filter coefficients of the basic low pass filter Lman are characterized in that the sum total of the numerical string is "1" and the total values of every other value of the numerical string have the same sign and the same value.

FIG.10 illustrates an example of the hardware structure of the basic low pass filter L4a4 (when m=4, n=4). As shown in FIG.10, an FIR calculation section 101 which has a numerical string "-1/2, 2, -1/2" which becomes a starting point as filter coefficients is constructed of two cascade connected D-type flip flops 1₋₁ and 1₋₂, three coefficient units 2₋₁ to 2₋₃ and two subtractors 3₋₁ and 3₋₂.

The two D-type flip flops 1-₁ and 1-₂ sequentially delay input data by one clock CK at a time. The three coefficient units 2-₁ to 2-₃ multiply the signals extracted from the input/output taps of the D-type flip flops 1₋₁ and 1₋₂ by filter coefficients of 1/2, 2, and 1/2, respectively. The first subtractor 3₋₁ subtracts a multiplication result of the first coefficient unit 2₋₁ from a multiplication result of the second coefficient unit 2₋₂. Furthermore, the second subtractor 3₋₂ subtracts a multiplication result of third coefficient unit 2₋₃ from a subtraction result of the first subtractor 3₋₁.

Furthermore, the moving average calculation section 201 which performs a moving average calculation to the above-mentioned numerical string "-1,/2, 2, -1/2" is constructed by cascade connecting four integrators 4₋₁ to 4₋₄ of the same structure. For example, the integrator 4₋₁ in the first stage is constructed of a D-type flip flop 5₋₁ that delays input data by one clock, an adder 6₋₁ that adds up original data which does not pass through the D-type flip flop 5-₁ and preceding data which has been delayed by passing through the D-type flip flop 5-₁ and an adjuster 7-₁ for restoring (weighting) the amplitude of the addition result.

According to the structure of the basic low pass filter L4a4 shown in this FIG.10, it is only the FIR calculation section 101 in the first stage that requires coefficient units 2-₁ to 2-₃ that multiply data by filter coefficients and output taps which are output ports of data for the coefficient units 2-₁ to 2-₃. Moreover, the number of the coefficient units and output taps is only three.

Moreover, since the values of the filter coefficients are 1/2, 2, and 1/2, the coefficient units 2₋₁ to 2₋₃ can be constructed of bit shift circuits. Furthermore, the adjusters 7₋₁ to 7₋₄ provided for the four integrators 4₋₁ to 4₋₄ can also be constructed of bit shift circuits. Even when the value of n is other than 4 and the number of adjusters is changed, all the adjusters can be constructed of bit shift circuits. Thus, no multiplier is required in the hardware structure of a basic low pass filter L4an.

Here, the case with m=4 has been explained, but if m=2ⁱ (i is an integer), all the coefficient units and adjusters can be constructed of bit shift circuits and no multiplier is required.

FIG.11 shows a frequency characteristic (frequency-gain characteristic and frequency-phase characteristic) obtained by FFT transforming the numerical string of the filter coefficients of the basic low pass filter L4a4. Here, the gain is expressed on a straight scale and the normalized gain is multiplied 32-fold. On the other hand, the frequency is normalized with "1".

As is appreciated from this FIG.11, a frequency-gain characteristic with a substantially flat pass band and an inhabitation band with a gentle inclination is obtained. Furthermore, a substantially rectilinear frequency-phase characteristic is also obtained. Thus, a low pass filter having a preferable frequency characteristic with no overshoot and ringing can be obtained only by structuring as in FIG. 10.

FIGS. 12A and 12B illustrate a frequency-gain characteristic of the basic low pass filter L4an, where n is a parameter, FIG. 12A shows the gain on a rectilinear scale and FIG. 12B shows the gain on a logarithmic scale. It is appreciated from FIG. 12 that the inclination of the inhibition band becomes steeper and the bandwidth of the pass band becomes narrower as the value of n increases. Furthermore, when the value of n is small, both ends of a vertex of the frequency characteristic rise. As the value of n increases, the vertex gradually flattens and becomes completely flat when n=4. When the value of n exceeds that value, then both ends of the vertex fall below the central value.

Here, the frequency characteristic when m=4 is shown here, but when the value of m is decreased, the inclination of the inhibition band becomes steeper and the bandwidth of the pass band becomes narrower. As stated above, it is possible to adjust the frequency characteristic of the basic low pass filter Lman by appropriately setting the values of parameters m and n.

### <Basic high pass filter Hmsn (m and n are variables, m is an arbitral number, n is a natural number)>

A basic high pass filter Hmsn is configured with an FIR calculation section that uses a numerical string "-1, m, -1" as filter coefficients and a moving average calculation section that sequentially performs a moving average calculation to a numerical string output from the FIR calculation section. The moving average calculation section, in this case, sequentially applies a moving average calculation to the original numeric string "-1, m, -1" such as by performing a moving average calculation wherein a present numeric string and a numeric string shifted by one sample (one clock) from the present numeric string and inverted its signs are added together with weighting (the total weighting value is "1") and by performing the same moving average calculation again to the obtained numeric string.

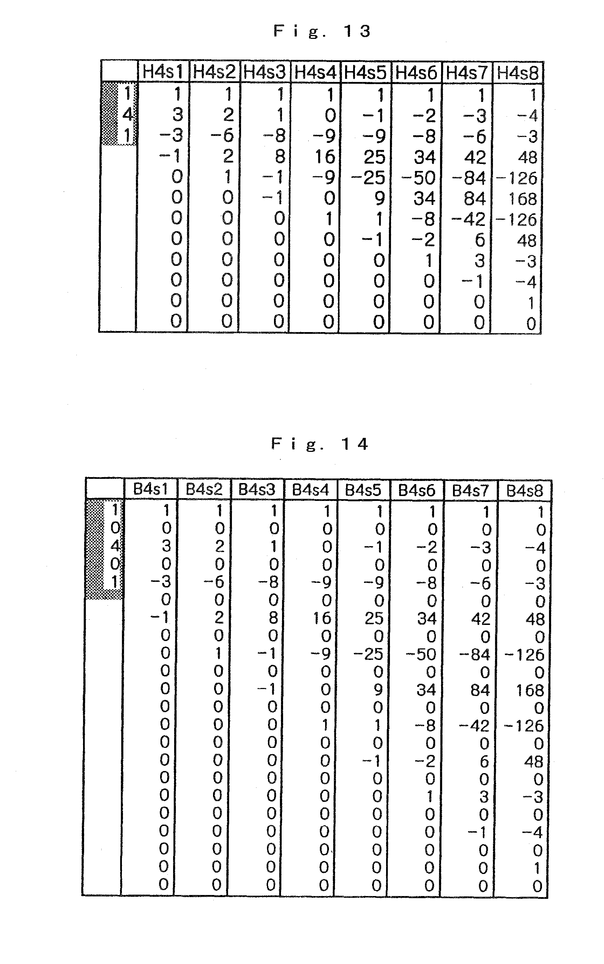

FIG. 13 illustrates filter coefficients of a basic high pass filter H4sn (when m=4) (a numeric string obtained when a numeric string of filter coefficients possessed by an FIR calculation section is subjected to a moving average calculation in a moving average calculation section). The numeric strings of filter coefficients shown in FIG. 13 are not normalized with "1" but the numerical values are converted into integers to be explained easily.

In FIG. 13, in obtaining the jth filter coefficient from top of the nth column by a moving average calculation, the jth data from top of the (n-1) th data column and the jth data from top of the data column shifted by one sample (one clock) from the (n-1) th data column and inverted in its signs are added together with weighting.

For example, the first numerical value "1" from top of the basic high pass filter H4s1 (firstcolumn) is obtained by subtracting from the original data "1" in first of the 0th column the data "0" preceding thereof by one sample and the second numerical value "3" is obtained by subtracting from the original data "4" in second of the 0th column the data "1" preceding thereof by one sample. Furthermore, the third numerical value "-3" is obtained by subtracting from the original data "1" in third of the 0th column the data "4" preceding thereof by one sample and the fourth numerical value "-1" is obtained by subtracting from the original data "0" in forth of the 0th column the data "1" preceding thereof by one sample. The weighting calculation is omitted in FIG. 13 in order to easily express numerical values in integers.

In a basic high pass filter H4sn shown in FIG. 13, when n is an even number, filter coefficients of any numerical string are symmetric and are characterized in that the total values of every other value of the numerical string have opposite signs and the same value (for example, in the case of a basic high pass filter H4s4, 1+(-9)+(-9)+1=-16, 0+16+0=16). When n is an odd number, the absolute values of the numerical string are symmetric and the first half numerical string and the second half numerical string have opposite signs. Furthermore, the filter coefficients are characterized in that the total values of every other value of the numerical string have the opposite signs and the same value.

When these numeric strings are actually used as filter coefficients, the amplitude when a numeric string of filter coefficients was subjected to an FFT transforming is adjusted to "1", whereby a gain is normalized to "1". For example, a numeric string of filter coefficients actually used in the FIR calculation section is not "1, 4, 1", but "1/2, 2, 1/2". Additionally, a numeric string actually used as filter coefficients (first filter coefficients) of an original filter after a moving average calculation is not {1, 0, -9, 16, -9, 0, 11, but "{1, 0, -9, 16, -9, 0, 1}/32, for example.

When the numerical string normalized as shown above is used as filter coefficients, the filter coefficients of the basic high pass filter Hmsn are characterized in that the sum total of the numerical string is "0" and the total values of every other value of the numerical string have the opposite signs and the same value.

The illustration of the hardware structure of the basic high pass filter Hmsn is omitted here, but it is constructed in the same way as shown in FIG. 10. That is, the basic high pass filter Hmsn is constructed of an FIR calculation section having a numeric string "1/2, 2, 1/2" as filter coefficients to be a starting point and a moving average calculation section that applies a moving average calculation to this numeric string. In the hardware structure of this basic high pass filter Hmsn, it is only the FIR calculation section in the first stage that requires output taps and there are only a small number of taps. Furthermore, no multiplier is required.

The illustration of the frequency characteristic of the basic high pass filter Hmsn will also be omitted. As in the case of the basic low pass filter Lman, the pass band of its frequency-gain characteristic is substantially flat and shows a characteristic with the inhibition band having a gentle inclination. Furthermore, its frequency-phase characteristic also shows a rectilinear characteristic. That is, it is possible to obtain a high pass filter with a good frequency characteristic with no overshoot or ringing. Here, when the value of n is increased, the inclination of the inhibition band becomes steeper and the bandwidth of the pass band becomes narrower. Furthermore, when the value of m is decreased, the inclination of the inhibition band becomes steeper and the bandwidth of the pass band becomes narrower.

### <Basic band pass filter Bmsm (m and n are variables, m is an arbitrary number, n is a natural number)>

A basic band pass filter Bmsn is configured with an FIR calculation section that uses a numerical string "1, 0, m, 0, 1" as filter coefficients and a moving average calculation section that sequentially performs a moving average calculation to a numerical string output from the FIR calculation section. The moving average calculation section, in this case, sequentially applies a moving average calculation to the original numeric string "1, 0, m, 0, 1" such as by performing amoving average calculation wherein a present numeric string and a numeric string shifted by two samples (two clocks) from the present numeric string and inverted its signs are added together with weighting (the total weighting value is "1") and by performing the same moving average calculation again to the obtained numeric string.

FIG. 14 illustrates filter coefficients of a basic band pass filter B4sn (when m=4) (a numeric string obtained when a numeric string of filter coefficients possessed by an FIR calculation section is subjected to a moving average calculation in a moving average calculation section). The numeric strings of filter coefficients shown in FIG. 14 are not normalized with "1" but the numerical values are converted into integers to be explained easily.

In FIG. 14, in obtaining the jth filter coefficient from top of the nth column by a moving average calculation, the jth data from top of the (n-1) th data column and the jth data from top of the data column shifted by two samples (two clocks) from the (n-1)th data column and inverted in its signs are added together with weighting.

For example, the first numerical value "1" from top of the basic bandpass filter B4sl (firstcolumn) is obtained by subtracting from the original data "1" in first of the 0th column the data "0" preceding thereof by two samples and the third numerical value "3" is obtained by subtracting from the original data "4" in third of the 0th column the data "1" preceding thereof by two samples. Furthermore, the fifth numerical value "-3" is obtained by subtracting from the original data "1" in fifth of the 0th column the data "4" preceding thereof by two samples and the seventh numerical value "-1" is obtained by subtracting from the original data "0" in seventh of the 0th column the data "1" preceding thereof by two samples. The weighting calculation is omitted in FIG. 14 in order to easily express numerical values in integers.

In a basic band pass filter B4sn shown in FIG. 14, when n is an even number, filter coefficients of any numerical string are symmetric and are characterized in that the total values of every three values of the numerical string have opposite signs and the same value (for example, in the case of a basic band pass filter B4s4, 1+ (-9) +(-9)+1=-16, 0+16+0=16). When n is an odd number, the absolute values of the numerical string are symmetric and the first half numerical string and the second half numerical string have opposite signs. Furthermore, the filter coefficients are characterized in that the total values of every three values of the numerical string have the opposite signs and the same value.

When these numeric strings are actually used as filter coefficients, the amplitude when a numeric string of filter coefficients was subjected to an FFT transforming is adjusted to "1", whereby a gain is normalized to "1". For example, a numeric string of filter coefficients actually used in the FIR calculation section is not "1, 0, 4, 0, 1", but "1/2, 0, 2, 0, 1/2". Additionally, a numeric string actually used as filter coefficients (first filter coefficients) of an original filter after a moving average calculation is not {1, 0, 0, 0, -9, 0, 16, 0, -9, 0, 0, 0, 1}, but "{1, 0, 0, 0, -9, 0, 16, 0, -9, 0, 0, 0, 1}/32, for example.

When the numerical string normalized as shown above is used as the filter coefficients, the filter coefficients of the basic band pass filter Bmsn are characterized in that the sum total of the numerical string is "0" and the total values of every three values of the numerical string have the opposite signs and the same value.

Here, the illustration of the hardware structure of the basic band pass filter Bmsn will be omitted, but it is constructed in the same way as in FIG. 10. That is, the basic band pass filter Bmsn is constructed of an FIR calculation section having a numeric string "1/2, 0, 2, 0, 1/2" which corresponds to the starting point as filter coefficients and a moving average calculation section that applies a moving average calculation to this numeric string. In the hardware structure of this basic band pass filter Bmsn, it is only the FIR calculation section in the first stage that requires the output taps and there are only a small number of taps. Furthermore, no multiplier is required.

The illustration of the frequency characteristic of the basic band pass filter Bmsn will also be omitted, but as in the case of the basic low pass filter Lman and basic high pass filter Hmsn, it shows a frequency-gain characteristic having a substantially flat pass band and an inhibition band with a gentle inclination. Furthermore, a rectilinear characteristic can be obtained as the frequency-phase characteristic. That is, it is possible to obtain a band pass filter having a good frequency characteristic with no overshoot or ringing. Here, when the value of n is increased, the inclination of the inhibition band becomes steeper and the bandwidth of the pass band becomes narrower. Furthermore, when the value of m is decreased, the inclination of the inhibition band becomes steeper and the bandwidth of the pass band becomes narrower.

When impulse responses of the above described three types of basic filters Lman, Hmsn, Bmsn are obtained, they form a function showing finite values other than "0" only when the sample position along the time axis is within a certain range with all values being "0" in other areas, that is, a function whose value converges to "0" at a predetermined sample position. Thus, the case where values of a function are finite values other than "0" in local areas and "0" in other areas is called "finite-base."

In such a finite-base impulse response, only data in a local area having a finite value other than "0" has a meaning. It is not the case that this data outside the area which originally should be considered is ignored but the data need not be considered theoretically, and therefore no truncation error occurs. Therefore, if the above described three types of basic filters Lman, Hmsn, Bmsn are used, it is not necessary to discard coefficients through windowing using a window function and it is possible to obtain a good filter characteristic.

According to the present invention as specifically described above, since the filters are designed by cascade connecting an original filter having the first filter coefficient of a symmetric numerical string and an adjustment filter having the second filter coefficient which attains an inverse frequency-amplitude characteristic contacting with a frequency-amplitude characteristic of the original filter at the maximum amplitude value, it is possible to simply design an FIR digital filter with an ideal frequency characteristic having a relatively wide pass band and an inhibition band having a steep inclination without using any window function or approximate expression.

In addition, the above described embodiment has merely explained examples of implementation of the present invention and the technological scope of the present invention should not be interpreted limited to the embodiment. That is, the present invention can be implemented in various forms without departing from the spirit of the present invention or major features thereof.

### [Industrial Applicability]

The present invention is suitable for use in a type of an FIR digital filter provided with a tapped delay line made up of a plurality of delayers, wherein output signals of the respective taps are multiplied several-fold by filter coefficients respectively and their multiplication results are added up and output and in a design method thereof.

## Claims

1. A design method of a digital filter which multiplies signals at taps of a tapped delay line made up of a plurality of delayers by given filter coefficients, adds up the multiplication results, and outputs the addition result, comprising:
a first step of generating a first filter coefficient of a symmetric numeric string;
a second step of obtaining a second filter coefficient realizing an inverse frequency-amplitude characteristic contacting with a frequency-amplitude characteristic expressed by said first filter coefficient at the maximum amplitude value; and
a third step of executing a calculation to obtain a third filter coefficient obtained when a first filter having said first filter coefficient and a second filter having said second filter coefficient are cascaded and determining said third filter coefficient generated in the calculation as the filter coefficient to be obtained,
wherein when the numeric string output when a single pulse is input to said first filter is expressed by {Hₘ, Hₘ₋₁, ..., H₁, H₀, H-₁, ..., H-₍ₘ₋₁₎, H-ₘ},
said second filter coefficient in said second step is obtained through a calculation {-kHₘ, -kHₘ₋₁, ..., -kH₁, -kH₀+(1+k), -kH₋₁, ..., -kH-₍ₘ₋₁₎, -kH-ₘ} (k is an arbitrary positive number).

2. The design method of the digital filter according to claim 1, wherein when the numeric string output when a single pulse is input to said first filter is expressed by {H_{m,} Hₘ₋₁, ..., H₁, H₀, H₀, H₋₁, ... , H-₍ₘ₋₁₎, H₋ₘ},
said second filter coefficient in said second step is obtained by multiplying numerical values of said numeric string (-k)-fold (k is an arbitral positive number), executing a fast Fourier transform to the multiplication results, adding k to numerical values of the transformed numeric string, and executing an inverse fast Fourier transform to the resulting numeric string.

3. A design method of a digital filter which multiplies signals at taps of a tapped delay line made up of a plurality of delayers by given filter coefficients, adds up the multiplication results, and outputs the addition result, comprising:
a first step of generating a first filter coefficient of a symmetric numeric string;
a second step of obtaining a second filter coefficient realizing an inverse frequency-amplitude characteristic contacting with a frequency-amplitude characteristic expressed by said first filter coefficient at the maximum amplitude value; and
a third step of executing a calculation to obtain a third filter coefficient obtained when a first filter having said first filter coefficient and a second filter having said second filter coefficient are cascaded and determining said third filter coefficient generated in the calculation as the filter coefficient to be obtained,
wherein when the numeric string output when a single pulse is input to said first filter is expressed by {Hₘ, Hₘ₋₁, ..., H₁, H₀, H₀, H₋₁, ..., H₋₍ₘ₋₁₎, H₋ₘ},
said second filter coefficient in said second step is obtained by multiplying numerical values of said numeric string (-k)-fold (k is an arbitral positive number), executing a fast Fourier transform to the multiplication results, adding k to numerical values of the transformed numeric string, and executing an inverse fast Fourier transform to the resulting numeric string.

4. The design method of the digital filter according to any one of claims 1 to 3, wherein using said third filter coefficient generated in said third step as said first filter coefficient, the processes in said second step and said third step are repeated two or more times to determine the filter coefficient generated in said third step which is the final stage as the filter coefficient to be obtained.

5. The design method of the digital filter according to any one of claims 1 to 3, wherein using said third filter coefficient generated in said third step as said first filter coefficient, the processes in said second step and said third step are repeated two or more times, and
said second filter coefficient is obtained assuming k≠1 in said second step in a middle stage of said repeated processes, said second filter coefficient is obtained assuming k=1 in said second step which is the final stage, and said third filter coefficient generated in said third step of the final stage is determined as the filter coefficient to be obtained.

6. A design device of a digital filter comprising:
filter coefficient storage means for storing data on a first filter coefficient of a symmetric numeric string; and
calculation means for executing, using the data stored in said basic filter coefficient storage means, a calculation to obtain a symmetric second filter coefficient realizing an inverse frequency-amplitude characteristic contacting with a frequency-amplitude characteristic expressed by said first filter coefficient at the maximum amplitude value and a calculation to obtain a third filter coefficient obtained when a first filter having said first filter coefficient and a second filter having said second filter coefficient are cascaded.

7. A digital filter design program for causing a computer to execute a processing procedure on the digital filter design method according to any one of claims 1 to 5.

8. A digital filter design program for causing a computer to function as the respective means according to claim 6.

9. A digital filter which multiplies signals at taps of a tapped delay line made up of a plurality of delayers by given filter coefficients, adds up the multiplication results, and outputs the addition result,
wherein said third filter coefficient determined by using the design method according to any one of claims 1 to 5 is set as a filter coefficient to signals at said taps.

10. A digital filter which multiplies signals at taps of a tapped delay line made up of a plurality of delayers by given filter coefficients, adds up the multiplication results, and outputs the addition result, comprising:
an original filter having a first filter coefficient of a symmetric numeric string; and
an adjustment filter having a symmetric second filter coefficient realizing an inverse frequency-amplitude characteristic contacting with a frequency-amplitude characteristic of said original filter at the maximum amplitude value,
wherein said original filter and said adjustment filter are cascaded.

11. The digital filter according to claim 10, wherein when the numerical string output from said original filter when a single pulse is input to said original filter is expressed by {Hₘ, Hₘ₋₁, ..., H₁, H₀, H₋₁, ..., H₋₍ₘ₋₁₎, H₋ₘ},
a second filter coefficient making up said adjustment filter is {-kHₘ, -kHₘ₋₁, ... , -kH₁, -kH₀+(1+k), -kH₋₁, ..., -kH-₍ₘ₋₁₎, -kH-ₘ} (k is an arbitrary positive number).

12. A digital filter which multiplies signals at taps of a tapped delay line made up of a plurality of delayers by given filter coefficients, adds up the multiplication results, and outputs the addition result, comprising:
an original filter having a first filter coefficient of a symmetric numeric string; and
a plurality of adjustment filters having a second filter coefficient of a symmetric numeric string, cascaded in that order,
wherein said second filter coefficients making up said plurality of adjustment filters are symmetric filter coefficients each realizing an inverse frequency-amplitude characteristic contacting at the maximum amplitude value with the frequency-amplitude characteristic specified by the numeric string output from an anterior filter when a single pulse is input to said original filter.

13. The digital filter according to claim 12, wherein when the numeric string output from said anterior filter is assumed to be {Hₘ, Hₘ₋₁, ..., H₁, H₀, H₋₁, ..., H-₍ₘ₋₁₎, H-ₘ},
a second filter coefficient making up said adjustment filter is {-kHₘ, -kHₘ₋₁, ..., -kH₁, -kH₀+(1+k) , -kH-₁, ..., -kH-₍ₘ₋₁₎, -kH-ₘ} (k is an arbitrary positive number).

14. The digital filter according to claim 13, comprising said original filter, one or more said adjustment filters in which said second filter coefficients are set as k≠1, and one or more said adjustment filters in which said second filter coefficients are set as k=1, cascaded in that order.
